Europäisches Patentamt

European Patent Office

Office européen des brevets

(11) Publication number: **0 115 037**
**B1**

# (12) EUROPEAN PATENT SPECIFICATION

(45) Date of publication of patent specification: **21.03.90**

(51) Int. Cl.⁵: **H 03 K 4/64**

(21) Application number: **83112893.9**

(22) Date of filing: **21.12.83**

(54) Cathode ray tube display deflection system.

(30) Priority: **26.01.83 US 461076**

(43) Date of publication of application:
**08.08.84 Bulletin 84/32**

(45) Publication of the grant of the patent:
**21.03.90 Bulletin 90/12**

(84) Designated Contracting States:
**DE FR GB IT**

(56) References cited:
**US-A-3 970 894**
**US-A-4 228 462**
**US-A-4 292 654**
**US-A-4 317 133**

(73) Proprietor: **International Business Machines
Corporation
Old Orchard Road
Armonk, N.Y. 10504 (US)**

(72) Inventor: **Bond, Paul William
RD7, Box 84-A
Kingston New York 12401 (US)**
Inventor: **Rockrohr, James Donald
500 Washington Ave., Apt. 5D
Kingston New York 12401 (US)**

(74) Representative: **Grant, Iain Murray
IBM United Kingdom Limited Intellectual
Property Department Hursley Park
Winchester Hampshire SO21 2JN (GB)**

Courier Press, Leamington Spa, England.

## Description

The present invention relates to cathode ray tube (CRT) display deflection systems and tackles the problem of preventing drift.

It is a requirement of a high resolution display system that the alpha-numeric characters do not undergo short term or long term drift in position on the CRT screen. This drift is caused by variations in delay between the horizontal sync pulse and the occurrence of the flyback interval in the horizontal deflection circuit. The duration of the flyback interval is very stable since it is determined by a stable LC resonant circuit consisting of the deflection yoke and a flyback capacitor that shunts the deflection yoke. The same cannot be said of the initiation of the flyback interval which occurs at the turning off of the horizontal yoke driver. Variations in the initiation time of a flyback interval can be caused by change in circuit or saturation delays caused by excitation voltage changes and temperature changes. In a fixed frequency scan system such as television, these variations in initiation of the flyback interval are usually controlled by a phase-locked-loop circuit. These phase-locked-loop circuits are frequency dependent and therefore impractical in a variable format alpha-numeric display system with a variable frequency scan.

US—A—4,063,133 discloses a frequency dependent horizontal deflection circuit which corrects for variations in retrace initiation which are not adjusted by synchronisation circuits.

US—A—4,263,615 describes an open loop circuit which synchronises the horizontal drive sweep with a range of input sync pulse widths.

US—A—4,317,133 discloses another form of cathode ray tube display deflection system, again based on a local oscillator, referred to as a reference signal generator, the signals from which are compared with signals derived from an externally applied synchronising signal, assumed to be synchronised, as applied, with the horizonal scanning frequency. While the deflection system of US—4,317,133 includes a component set in many ways equivalent to the component set of the embodiment of the present invention disclosed hereinafter, the object sought to be achieved thereby and the assumptions made therefor are quite different and "suffer" from the frequency limitations that arise from being dependent on a local oscillator. Since US—A—4,317,133 is not intended to handle centring in variable format displays but only to ensure the linearity and stability of the amplitude of the deflection current in a fixed format display, the limitations imposed can be accommodated. This is why the synchronisation of the external pulse to the horizontal scanning frequency can be assumed to be established by means or default before the signal is applied to the deflection system and compared, more or less directly with the output from the local reference oscillator. In the case of the present invention, to accommodate variable formats indicated by externally applied parameter signals and still ensure centring, the reference oscillator has been dispensed with.

Therefore, other means have been needed to be devised to assure fixed delay between the start of the horizontal sync pulse and the initiation of the flyback interval.

The present invention provides a cathode ray tube display deflection system in a variable format alpha-numeric display system with variable frequency scan, the deflection system being responsive to an external synchronising signal and external format parameter signals and including a deflection yoke coil, a coil drive generating a ramp current in the coil and an oscillator-free drift compensated drive control including:

(a) first means responsive to the ramp current in the coil for generating a flyback pulse defining the flyback period;

(b) second means generating a ramp voltage during the deflection period of the coil ramp current following each synchronising signal;

(c) third means deriving a measure of the relative durations of the pre- and post-ramp voltage termination portions of the pulse defined flyback period;

(d) fourth means responsive to the second and third means generating a timed control pulse which resets the coil ramp current, thereby initiating the flyback pulse, and which is advanced or retarded relative to the preceding control pulse in such a way as to tend to maintain a constant ratio of the flyback pulse portions; and

(e) fifth means generating a start pulse for the coil ramp current following the resetting by the fourth means.

In an embodiment of the invention described in greater detail hereafter, a variable format CRT display is driven by a transistor which is turned-off by a synchronising pulse and is turned on when the ramp current generated by a diode and capacitor circuit reaches a settable threshold. Drift compensation is exercised by a delay mechanism, fired by the synchronising pulse, which sets a latch, quenching the transistor and allowing the capacitor to charge through a variable resistance When the ramp voltage attains the voltage of a second capacitor, the comparator generates a pulse setting the latch and turning off the transistor. The flyback current is clipped to a pulse which fires the transistor to enable a current mirror to change the capacitor until the ramp voltage reaches a reference value, whereat the capacitor discharges. If the discharge is not centred on pulse, the charged state of capacitor will vary to tend to maintain centring. Externall applied parameter signals exercise gross control.

The present invention will be described further by way of example with reference to one embodiment thereof as illustrated in the accompanying drawings, wherein:

Figure 1 is a schematic circuit diagram of one form of flyback pulse synchronisation circuit in accordance with the present invention;

Figure 2 is a plot of pertinent waveforms of the circuit of Figure 1 to two distinct scales; and

Figure 3 is a schematic logic diagram of the set dominant latches of Figure 1.

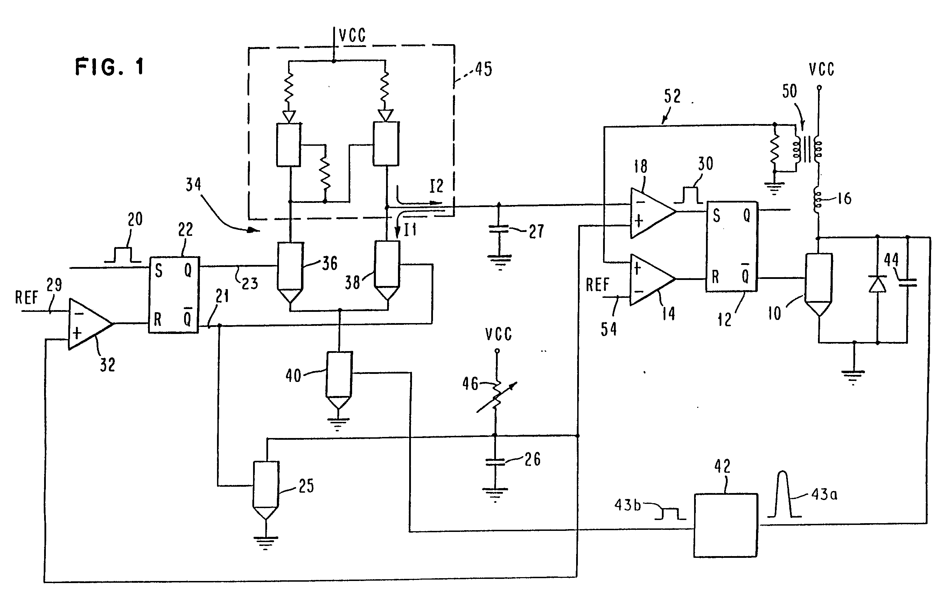

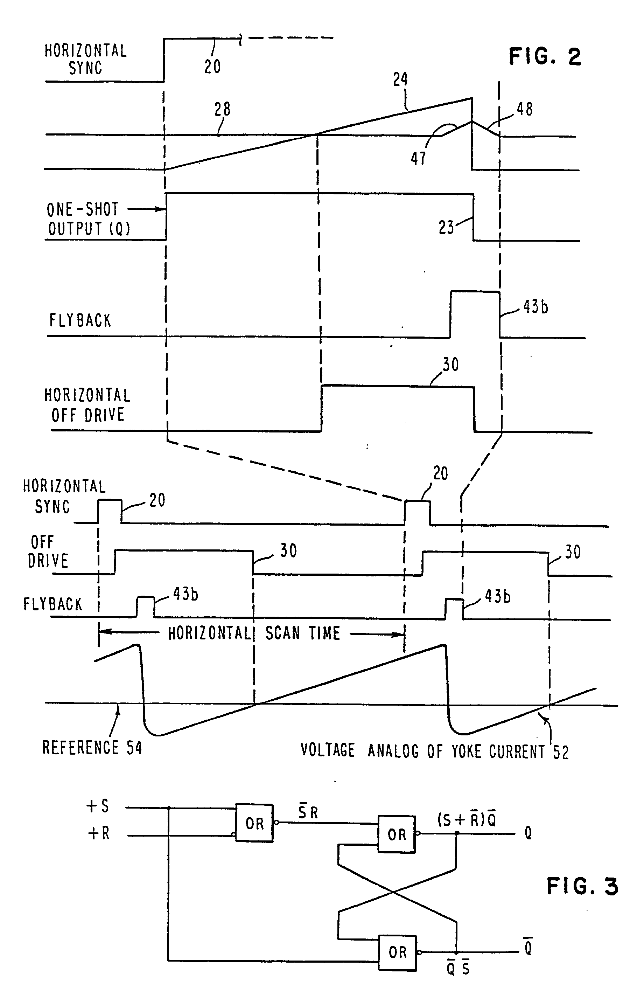

Referring now to Figures 1 and 2, the start of the flyback interval starts with the turning off of the drive transistor 10 for the horizontal deflection yoke coil 16. The input to the drive transistor 10 is taken from the $\overline{Q}$ state output of a latch 12. Latch 12 is a set dominant latch shown in detail in Figure 3. That is when the latch set input, S, goes up the latch is totally non-responsive to its reset input, R. When the set input, S, goes down the latch 12 will respond to the output of comparator 14 fed to the reset input R. Comparator 14 compares a voltage 52 which is proportional to the current through the yoke 16, which is generated by current transformer 50, to a reference level and when that voltage exceeds the reference level it provides a positive level at the reset input R of the latch 12. When the set input S is down this raises the $\overline{Q}$ output of the latch 12 causing conduction of transistor 10. The reference level, applied at 54 to comparator 14 is set such that the reset input R of latch 12 will raise $\overline{Q}$ and turn on transistor 10 just before it is required to begin conduction. Termination of conduction of the drive transistor 10 and the initiation of the flyback interval is controlled by the set input S.

The signal applied to the set input S of the latch 12 is the output of a second comparator 18. The second comparator 18 produces a positive output level in response to the horizontal sync pulse 20. The horizontal sync pulse 2 is fed into the set inputs of a second latch 22 thereby turning off the $\overline{Q}$ output 21 of the latch 22 and turning on the Q output 23 of the latch 22. When the $\overline{Q}$ output goes down transistor 25 is biased off allowing capacitor 26 to charge and raise the voltage at the positive terminal of comparator 18. As the voltage rises in a ramp 24 it eventually exceeds a variable reference potential 28 at the negative input to comparator 18. When this occurs the output of comparator 18 goes up producing the horizontal off-drive pulse 30. The horizontal off-drive pulse 30 drops the $\overline{Q}$ output of the latch 12 turning off transistor 10 and thereby starting the flyback interval. The voltage 24 continues to rise until it exceeds the reference level 29 fed to the negative input of a third comparator 32. When it does, the reset input of the latch 22 goes up, dropping the voltage on the Q output and raising the voltage on the $\overline{Q}$ output 21. When the Q output goes up, transistor 25 conducts shorting capacitor 26 to ground terminating the ramp or sawtooth voltage 24 and with it the horizontal off drive pulse 30. With the horizontal drive pulse down, the latch 12 can again respond to its reset input R and is ready to repeat the described cycle.

So long as half the flyback interval occurs before the termination of the sawtooth and the other half occurs after the termination thereof, the flyback interval is properly timed relative to the horizontal sync pulse. To maintain this timing, the magnitude of the voltage 28 on capacitor 27 is raised or lowered to advance or retard the start of the horizontal off-drive pulse 30. This is accomplished by using a differential current switch 34. The Q output 23 of latch 22 is fed to the base of transistor 36 and the $\overline{Q}$ output 21 of latch 22 is fed to the base of transistor 38 of the differential current switch 34. The emitters of the two transistors are connected to transistor 40 which is controlled by the output of a pulse shaper 42 that clips an input voltage 43a derived by connecting the input terminal across the flyback capacitor 44 so that the output 43b of the pulse shaper is up when the flyback voltage is up and down when the flyback voltage is down. The load for the differential current switch 34 is a unity current mirror 45 so that $I_1 = I_2$ where $I_2$ is the current charging capacitor 27 when transistors 36 and 40 are both conducting and $I_1$ is the current discharging capacitor 27 when both transistors 38 and 40 are conducting.

If the duration of currents $I_1$ and $I_2$ are equal, as is the case when the conduction of transistor 40 is centred with respect to the drop in the sawtooth voltage 26, capacitor 27 will have been charged slightly and then discharged by the same amount to return to its initial charge condition. This is shown at 47, 48 in Figure 2. If the initiation of flyback is late because of saturation delays in the response of the flyback circuit to off-drive signal 30, the termination of ramp 24 will be delayed and thus current $I_2$ will flow for a shorter period before the switching of 26 terminates it and the flow of current $I_1$ will continue for a correspondingly longer period before being terminated by the reopening of 40. This will decrease the charge across capacitor 27 whereby the ramp 26 will reach voltage level on line 28 sooner, thereby advancing the beginning of the off-drive signal 30. Thus, the circuit will return to a balanced condition wherein the flyback action will be centred about the drop in the sawtooth potential 26. It should be apparent from the above description that the effect of an advance in the initiation of the flyback period would be to increase the potential across capacitor 27 and thereby impede the start of the off-drive pulse 30.

Horizontal centring can be accomplished in a simple manner by making resistance R of the R, C ramp circuit 46, 26 adjustable as indicated at 46 so as to vary the slope of ramp 24. This can be done electronically by circuits responsive to the screen format control (not shown) of the display. Adjustment of the length of the sawtooth and therefore the delay in initiation of the flyback interval is accomplished by changing the reference potential 29 supplied to comparator 32. Increasing the reference potential 29 would have the effect of increasing the delay and decreasing the potential would have the effect of decreasing the delay. The reference potential 29 would be selected so that the length of the sawtooth voltage 24 is equal to the desired delay plus one half the flyback interval 43.

It will be apparent to those skilled in the art, that many modifications and changes can be made in this described embodiment without departing from the scope of the appended claims.

## Claims

1. A cathode ray tube display deflection system in a variable format alpha-numeric display system with variable frequency scan, the deflection system being responsive to an external synchronising signal (20) and external format parameter signals (29, 54) and including a deflection yoke coil (16), a coil drive (10, 44) generating a ramp current in the coil and an oscillator-free drift compensated drive control including:

(a) first means (42) responsive to the ramp current n the coil for generating a flyback pulse defining the flyback period;

(b) second means (25, 26, 46) generating a ramp voltage during the deflection period of the coil ramp current following each synchronising panel (20);

(c) third means (27, 34, 40, 45) deriving a measure of the relative durations of the pre- and post-ramp voltage termination portions of the pulse defined flyback period;

(d) fourth means (18) resonsive to the second and third means generating a timed control pulse (30) which resets the coil ramp current, thereby initiating the flyback pulse, and which is advanced or retarded relative to the preceding control pulse in such a way as to tend to maintain a constant ratio of the flyback pulse portions; and

(e) fifth means (14, 50) generating a start pulse for the coil ramp current following the resetting by the fourth means.

2. A system as claimed in Claim 1 wherein the second means includes an externally variable component (46) responsive to one of the external format parameter signals by means of which the centring of the deflection produced by the coil drive can be adjusted.

3. A system as claimed in either preceding claims wherein the third means (32) has an adjustable input responsive to another one of the external format parameter signals (29) by means of which the delay between the start of the ramp current generation and the flyback initiation can be adjusted to vary the trace length.

4. A system as claimed in any preceding claim in which the fourth means has an externally adjustable input (14, 12) responsive to another of the external format parameter signals (54) by means of which the centring of the drive can be adjusted.

5. A system as claimed in any preceding claim wherein the coil drive includes an inductive "spring" (44) generating the flyback pulse, on release of the driver, the fourth means including a latch (12) of the kind having a predominant state, established by the control pulses, in which the driver (10) is ineffective, its minor state, in which the driver is effective, being established by attainment of a threshold by the coil current.

6. A system as claimed in any preceding claim in which the third means comprises a capacitance (27), connected to a charging/discharging circuit, enabled for either operation by each flyback pulse and switched, in operation, by a signal (21) which terminates ramp voltage generation by the second means.

7. A system as claimed in any preceding claim wherein the second means comprises a capacitance (26) and the variable component (46) is a reactance and is connected in series, their common node being dischargeable through a transistor (25) and defining the ramp voltage as it recharges when the transistor is enabled in response to the synchronising signals, the common node voltage (24) being compared (at 32) with a reference voltage (29) to generate an enabling signal (21) to the transistor.

## Patentansprüche

1. Kathodenstrahlröhren-Anzeige-Ablenksystem in einem alphanumerischen System mit variablem Format, mit variabler Abtastfrequenz, das auf ein externes Synchronisiersignal (20) und externe Formatparametersignale (29, 54) anspricht, mit einer Umlenkjochspule (16), einem Spulenantrieb (10, 44), einen Rampenstrom in der Spule erzeugend, und einer schwindigungsfreien ausgeglichenen Antgriebssteuerung, enthaltend:

(a) ein erstes Mittel (42), das auf den Rampenstrom in der Spule anspricht, um einen Rücklaufimpuls zu erzeugen, die die Rücklaufperiode festlegt;

(b) ein zweites Mittel (23, 26, 46), das eine Rampenspannung während der Ablenkzeit des Spulenrampenstroms erzeugt, der jedem Synchronisiersignal (20) folgt;

(c) ein drittes Mittel (27 34, 40, 45), das eine Messung der relativen Dauern der Endabschnitte vor und nach dem Rampenstrom der durch den Implus definierten Rücklaufzeit ableitet;

(d) ein viertes Mittel (18), das auf die zweiten und dritten Mittel anspricht, und einen Zeitsteuerimpuls (30) erzeugt, der den Spulenrampenstrom zurücksetzt, dadurch einen Rücklaufimpuls einleitet, und der auf den vorangehenden Steuerimpuls in solcher Weise vorgezogen oder verzögert wird, daß die Rücklaufimpulse in einem möglichst konstanten Verhältnis gehalten werden; und

(e) ein fünftes Mittel (14, 50), das einen Startimpuls für en Spulenrampenstrom nach der Rückstellung durch das vierte Mittel erzeugt.

2. System gemäß Anspruch 1, in dem das zweite Mittel ein extern verstellbares Bauteil (46) enthält, das auf einen der externen Formatparametersignale anspricht, wodurch sich die Zentrierung der Ablenkung durch den Spulenantrieb nachstellen läßt.

3. System gemäß einem der vorangehenden Ansprüche, in dem das dritte Mittel (32) einen verstellbaren Eingang besitzt, der auf ein weiteres der externen Formatparametersignale (29) anspricht, wodurch die Verzögerung zwischen dem Start des Rampenerzeugungsstroms und der Einleitung des Rücklaufimpulses eingestellt werden kann, um die Spurlänge zu verändern.

4. System gemäß einem der vorangehenden Ansprüche, in dem das vierte Mittel einen extern verstellbaren Eingang (14, 12) besitzt, der auf ein anderes der extern verstellbaren Formatparametersignale (54) anspricht, wodurch die Zentrierung des Laufwerks nachgestellt werden kann.

5. System gemäß einem der vorangehenden Ansprüche, in dem der Spulenantrieb eine induktive "Feder" enthält (44), die den Rücklaufimpuls generiert bei Freigabe des Antriebs, wobei das vierte Mittel einen Riegel (12) von der Art mit einem dominierenden Zustand hat, durch die Kontrollimpulse erstellt, in dem der Antrieb (10) unwirksam ist, während der nächste Zustand, in dem der Antrieb wirksam ist, durch Erreichen einer Schwelle durch den Spulenstrom hergestellt wird.

6. System gemäß einem der vorangehenden Ansprüche, in dem das dritte Mittel einen Kondensator (27) enthält, der an einen Lade-/Entladekreis angeschlossen ist, und für jede Betätigung durch jeden Rücklaufimpuls freigegeben und während des Betriebs durch ein Signal (21) umgeschaltet wird, das die Erzeugung des Rampenstros durch das zweite Mittel beendet.

7. System gemäß einem der vorangehenden Ansprüche, in dem das zweite Mittel einen Kondensator (26) enthält, und das variable Bauteil (46) ein in Serie geschalteter Blindwiderstand ist, wobei sich deren gemeinsamer Punkt durch einen Transistor (25) entlädt und die Rampenspannung definiert, während er sich wieder auflädt, wenn der Transistor als Antwort auf die Synchronisiersignale leitend wird, und die Spannung am gemeinsamen Punkt (24) (in 32) mit einer Bezugsspannung (29) verglichen wird, um ein Feigabesignal (21) in den Transistor zu geben.

## Revendications

1. Système de déviation pour un dispositif d'affichage à tube cathodique, dans un système d'afficharge alphanumérique à format variable, à balayage à fréquence variable, le système de déviation étant sensible au signal extérieur de synchronisation (20) et à des signaux extérieurs (29, 54) de paramètres de formats et incluant une bobine (16) d'un collier de déviation, un étage (10, 44) d'attaque de la bobine, produisant un courant en forme de rampe dans la bobine et un système de commande à dérive compensée, sans oscillateur, incluant:

a) des premiers moyens (42) sensibles au courant en forme de rampe circulant dans la bobine pour produire une impulsion de retour du spot, définissant la période de retour du spot;

b) des seconds moyens (25, 26, 46) produisant une tension en forme de jampe pendant la période de déviation du courant de bobine en forme de rampe, intervenant à la suite de chaque signal de synchronisation (20);

c) des troisième moyens (27, 34, 40, 45) dérivant une mesure des durées relatives des parties terminales de la tension se situant avant et après la partie en forme de rampe, de la période de retour du spot définie par des impulsions;

d) des quatrièmes moyens (18) sensibles aux seconds et troisièmes moyens et délivrant une impulsion de commande cadencée (30), qui supprime le courant en forme de rampe de la bobine, ce qui déclenche l'impulsion de retour du spot, et qui est en avance ou en retard par rapport à l'impulsion précédente de commande de manière à tendre au maintien d'un rapport constant des parties des impulsions de retour du spot; et

e) des cinquièmes moyens (14, 50) produisant une impulsion de démarrage pour le courant en forme en rampe de la bobine à la suite de la remise à zéro réalisée par les quatrièmes moyens.

2. Système selon la revendication 1, dans lequel les seconds moyens incluent un composant (46), modifiable de l'extérieur, sensible à l'un des signaux extérieures de paramètres de formats et qui permet de régler le centrage de la déviation produite par l'étage d'attaque de la bobine.

3. Système selon l'une des revendications précédentes, dans lequel les troisièmes moyens (32) comportent une entrée réglable sensible à un autre des signaux externes de paramètres de formats (29), à l'aide duquel le retard entre le débit de la production du courant en forme de rampe et le déclenchement du retard du spot peuvent être réglés de manière à modifier la longueur du tracé.

4. Système selon l'une quelconque des revendications précédentes, dans lequel les quatrièmes moyens possèdent une entrée (14, 12), réglable de l'extérieure et sensible à un autre des signaux externes de paramètres de formats (54), à l'aide desquels le centrage de l'étage d'attaque peut être réglé.

5. Système selon l'une quelconque des revendications précédentes, dans lequel l'étage d'attaque de la bobine inclut un "ressort" inductif (44) produisant l'impulsion de retour du spot, lors de la libération de l'étage d'attaque, les quatrièmes moyens incluant une bascule bistable (12) du type comportant un état prédominant, qui est établi par les impulsions de commande et dans lequel l'étage d'attaque (10) est inactif, l'état secondaire de l'étage d'attaque, dans lequel ce dernier est actif, état établi lorsqu'un seuil est atteint par le courant de la bobine.

6. Système selon l'une quelconque des revedications précédentes, dans lequel les troisièmes moyens comprennent une capacité (27) raccordée à un circuit de charge/décharge, validé pour soit être activé par chaque impulsion de retour du spot, soit être commuté, en fonctionnement, par un signal (21) qui interrompt la production de la tension en forme de rampe par les seconds moyens.

7. Système selon l'une quelconque des revendications précédentes, dans lequel les seconds moyens comprennent une capacité (26), et le composant variable (26) est une réactance et est branché en série, leur noeud commun pouvant être déchargé dans un transistor (25) et défnissant la tension en forme de rampe lorsqu'elle se rétablit, lorsque le transistor est rendu conducteur en réponse aux signaux de synchronisation, la tension (24) sur le noeud commun état comparée (en 32) à une tension de référence (29) servant à envoyer au transistor au signal (21) de mise à l'état conducteur.

FIG. 1

EP 0 115 037 B1

FIG. 2

HORIZONTAL SYNC

ONE-SHOT OUTPUT (Q)

FLYBACK

HORIZONTAL OFF DRIVE

HORIZONTAL SYNC

OFF DRIVE

FLYBACK

HORIZONTAL SCAN TIME

REFERENCE 54

VOLTAGE ANALOG OF YOKE CURRENT 52

FIG. 3

2